# EUROPEAN PATENT APPLICATION

(11) **EP 2 709 162 A1**
(43) Date of publication of application: **19.03.2014**
(21) Application number: 12184211.6
(22) Date of filing: 13.09.2012
(51) Int. Cl.: H01L 31/0352, H01L 31/18, H01L 31/0224, H01L 31/068

(54) **Photovoltaic cell and photovoltaic cell module based thereon**

(71) Applicant: Roth & Rau AG, 09337 Hohenstein-Ernstthal (DE)
(72) Inventor: Lachenal, Damien, 2022 Bevaix (CH); Papet, Pierre, 2068 Hauterive (CH)
(74) Representative: Steiniger, Carmen

(57) **Abstract**

The present invention relates to a photovoltaic cell (solar cell) with at least one base of a first polarity and at least one emitter of a second polarity and having a front side for receiving light and a back side opposite said front side, wherein base contact structure elements contacting the at least one base and emitter contact structure elements contacting the at least one emitter are formed on said back side separately from each other; wherein the base contact structure elements are connected electrically by base connector lines provided on the base contact structure elements and the emitter contact structure elements are connected electrically by emitter connector lines provided on the emitter contact structure elements, wherein the base connector lines and the emitter connector lines extend longitudinally side by side, distanced from each other and alternately over the back side of the photovoltaic cell, respectively; the base contact structure elements and the emitter contact structure elements comprise base contact islands and emitter contact islands being spaced apart from each other; the base contact islands and the emitter contact islands have lengths extending longitudinally in a direction transverse to a longitudinal direction of the base connector lines and the emitter connector lines, respectively, and have such a length that the base contact islands and the emitter contact islands interfinger; and wherein each of the base connector lines connects a group of base contact islands by crossing the base contact islands in the longitudinal direction and each of the emitter connector lines connects a group of emitter contact islands by crossing the emitter contact islands in the longitudinal direction. The invention further relates to a photovoltaic cell module (solar cell module) comprising at least two photovoltaic cells of this type being electrically connected with each other. It is therefore the object of the present invention to improve the IBC solar cell of the above mentioned type in such way that the base and emitter contact structures collect the current more effectively, wherein the IBC solar cell shall be producible at low costs. The object is solved by a solar cell of the above mentioned type wherein the base connector lines and the emitter connector lines have such a width in the direction transverse to the longitudinal direction of the base and emitter connector lines that there is a direct contact between each of the connector lines and the corresponding base contact islands and emitter contact islands over the full width of the connector lines in the regions where the base connector lines cross the base contact islands and in the regions where the emitter connector lines cross the base connector islands, respectively, wherein the base connector lines do not overlap the emitter contact islands in the direction transverse to the longitudinal direction of the base and emitter connector lines and the emitter connector lines do not overlap the base contact islands in the direction transverse to the longitudinal direction of the base and emitter connector lines.

## Description

The present invention relates to a photovoltaic cell (solar cell) with at least one base of a first polarity and at least one emitter of a second polarity and having a front side for receiving light and a back side opposite said front side, wherein base contact structure elements contacting the at least one base and emitter contact structure elements contacting the at least one emitter are formed on said back side separately from each other; wherein the base contact structure elements are connected electrically by base connector lines provided on the base contact structure elements and the emitter contact structure elements are connected electrically by emitter connector lines provided on the emitter contact structure elements, wherein the base connector lines and the emitter connector lines extend longitudinally side by side, distanced from each other and alternately over the back side of the photovoltaic cell, respectively; the base contact structure elements and the emitter contact structure elements comprise base contact islands and emitter contact islands being spaced apart from each other; the base contact islands and the emitter contact islands have lengths extending longitudinally in a direction transverse to a longitudinal direction of the base connector lines and the emitter connector lines, respectively, and have such a length that the base contact islands and the emitter contact islands interfinger; and wherein each of the base connector lines connects a group of base contact islands by crossing the base contact islands in the longitudinal direction and each of the emitter connector lines connects a group of emitter contact islands by crossing the emitter contact islands in the longitudinal direction. The invention further relates to a photovoltaic cell module (solar cell module) comprising at least two photovoltaic cells of this type being electrically connected with each other.

In the description of the present invention as well as in the claims, the expressions "photovoltaic cell", "PV cell" and "solar cell" are used as synonyms.

Photovoltaic cells consist typically of a semiconductor substrate, such as a silicon substrate, having a front side for receiving light and a back side opposite the front side. In the substrate, at least one semiconductor junction defined by junction-forming regions of first and second polarities is formed. The regions of first and second polarities are regions with n- or p-doping, respectively, and comprise at least one emitter with a first polarity and at least one base of a second polarity.

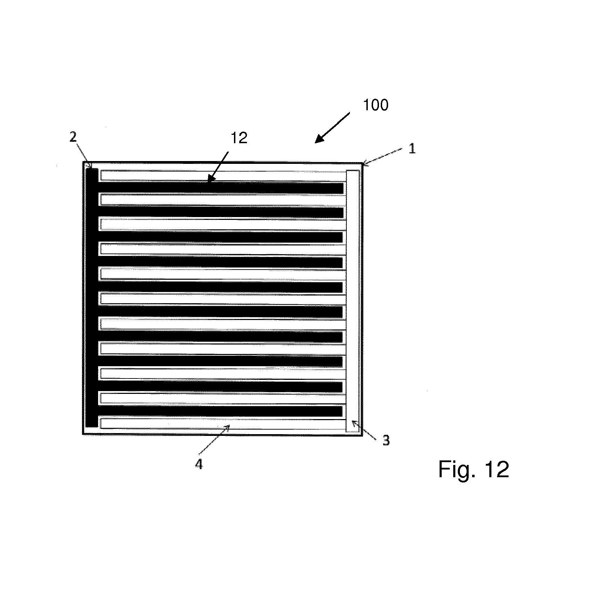

Recently, solar cells of back contact type get more and more interest, since in these solar cells the electrode and electrical conductors associated therewith are on the back side of the solar cells and therefore impose no shading on the front sides of the solar cells leading to higher efficiencies. In interdigitated back contact (IBC) photovoltaic (PV) cells, the regions of different polarities are electrically contacted on the back side of the solar cell at interdigitated contacts. This is conventionally made by forming on the back side of the solar cell a plurality of alternate fingers connected to semiconductor junction forming regions of opposite polarity. This way, the fingers serve as base contact structure elements contacting the at least one base and emitter contact structure elements contacting the at least one emitter of the respective solar cell. This principle is shown in Fig. 12 where, for example, a first plurality of fingers 4 is formed on a PV substrate 1 of a conventional IBC solar cell 100 to connect n- or n⁺-doped regions of that substrate 1 and a second plurality of fingers 12 is formed on the PV substrate 1 to connect p- or p⁺-doped regions of that substrate 1. The first plurality of fingers 4 is connected by a bus bar 3 and the second plurality of fingers 12 is connected by a bus bar 2, the bus bars 2, 3 being provided on opposite margin sides of the substrate 1. This way, the contact structures have a comb like shape.

The fingers 4, 12 allow collecting and carrying the current generated in the PV cell on the overall back side surface of the solar cell to the bus bars. The bus bars 2, 3 act as external connection points for module interconnection of the solar cell 100. The fingers 4, 12 are long and narrow structures of a metal material such as silver and have a length approximately equal to one cell dimension. Typical fingers of the state of the art have a width of between about 50 to 150 µm, a height of about 2 to about 30 µm and a lateral spacing of between about 1 and 5 mm. Due to the small cross section of the fingers and their long length, the electrical performances of IBC solar cells are strongly sensitive to the current flow along these fingers.

To minimize the losses resulting therefrom, in the state of the art thick fingers with a height of about 30 µm containing very conductive material such as copper are used. This metallization is formed by electroplating technique which is complex and expensive for the solar cell fabrication.

An IBC photovoltaic cell of the above mentioned type is known from the document WO 2011/011855 A1. The described PV cell comprises first and second pluralities of exposed metal contact portions being arranged in a checkerboard pattern across the back side of the solar cell, said first and second pluralities of exposed metal contact portions connect corresponding semiconductor regions of the solar cell with first and second polarity, respectively. Hence, the first and the second plurality of exposed metal contact portions form a first and a second set with rows and columns, wherein these sets are spaced apart from each other in two orthogonal directions so that the exposed metal contact portions do not overlap.

The exposed metal contact portions can be connected by parallel grid lines but can also be formed as physically separate elongate-shaped metal segments arranged in a plurality of parallel spaced apart lines extending across the back side of the solar cell. The metal segments have a length of about 1 to 3 mm, wherein the spacing between the rows is approximately equal to the length of the segments and the spacing to the next adjacent row of opposite polarity is about 0.5 to 3 mm. Each row of the first plurality of metal segments and each row of the second plurality of metal segments is connected, respectively, by an electrical conductor extending over the solar cell, wherein first and second sets of the electrical conductors connecting opposite doped semiconductor regions, respectively, are formed alternately and in parallel on the back side of the solar cell. The electrical conductors are strings having distal ends being connected with metallic foil bus bar formed on opposite sides to connect of the first set of electrical conductors and to connect the second set of electrical conductors. Thus, positive and negative terminals of the PV cell are formed.

To connect such solar cells with each other, solar cells having an equal pattern of exposed metal portions but being associated with junction-forming regions of opposite polarity are placed adjacent to each other and connected by electrodes. The opposite arrangement of junction forming regions of the solar cells to connect can be provided by rotating the second solar cell 180 degrees relative to the orientation of the first solar cell. This way, the exposed metal contact portions on the first solar cell associated with the first polarity can be connected with the exposed metal contact portions of the second solar cell associated with the second polarity, and vice versa.

Although the solar cell concept suggested in the document WO 2011/011855 A1 provides some advantages with regard to cell production costs due to reduced silver usage for forming the fingers, it suffers from a relatively high place required for the spaced apart exposed metal contact portions leading to an unsatisfying collection of current by these metal contact portions.

The document US 2011/0041908 A1 discloses a rear contact solar cell, wherein elongate emitter regions and elongate base regions are provided in a semiconductor substrate in an interleaved manner on the surface of the rear side of the solar cell. The emitter and base regions are contacted by a coarse mesh of elongate emitter and base contacts that extend in a right angle thereto. The emitter and base contacts cover the emitter and base regions over relatively broad regions. Thus, the emitter contacts overlap base regions and the base contacts overlap emitter regions. Therefore, an electrically insulating layer is provided in the vertical direction between the emitter contacts and the base regions and between the base contacts and the emitter regions. The contacts contact locally the emitter and base regions, respectively, positioned under the insulating layer merely at openings in the insulating layer. This kind of solar cell provides good current collecting properties but needs a lot of steps for the contact formation leading to increased costs of manufacturing.

It is therefore the object of the present invention to improve the IBC solar cell of the above mentioned type in such way that the base and emitter contact structures collect the current more effectively, wherein the IBC solar cell shall be producible at low costs.

The object is solved by a solar cell of the above mentioned type wherein the base connector lines and the emitter connector lines have such a width in the direction transverse to the longitudinal direction of the base and emitter connector lines that there is a direct contact between each of the connector lines and the corresponding base contact islands and emitter contact islands over the full width of the connector lines in the regions where the base connector lines cross the base contact islands and in the regions where the emitter connector lines cross the emitter connector islands, respectively, wherein the base connector lines do not overlap the emitter contact islands in the direction transverse to the longitudinal direction of the base and emitter connector lines and the emitter connector lines do not overlap the base contact islands in the direction transverse to the longitudinal direction of the base and emitter connector lines. That means, the connector lines are smaller in width than the distance between contact islands of same polarity.

Instead of using fingers that are continuous from one side of the solar cell to the other side of the solar cell, the present invention suggests the use of contact islands to contact the differently doped regions of the solar cell. In contrast to the known fingers of the state of the art, the base and emitter contact structure elements of the present invention are interrupted into short sections named contact islands. Moreover, the contact islands are arranged in such a way and have such a length that those contact islands which contact semiconductor regions with opposite polarity interfinger.

There are several advantages reached by the present invention.

First, the present invention leads to a decrease of ohmic losses per "finger" without using thick metallization for forming the base and emitter contact structure elements. In the inventive concept of IBC back side structuring, the current flows only through half the island length before being collected by a connector line such as a perpendicular ribbon. Therefore, the ohmic losses of the contact islands can be strongly reduced. In particular, the length of the contact islands used in the present invention can be for instance about 1/8 the length of a conventional finger, and the height of these contact islands can be strongly reduced in comparison to standard IBC solar cells, too. For example, whereas the height of fingers used in standard IBC solar cells is about 30 µm, the height of the contact islands used in the present invention can be of about 0.5 µm. This leads to a benefiting reduction of the serial resistance of the corresponding solar cell.

Second, due to the interlocking but not overlapping or touching contact islands, the current from the underlying doped regions can be collected in a very efficient manner. Moreover, by this arrangement, the size of the solar cell can be optimized.

Third, the possibility to use extremely thin - that means only several 100 nanometers thick - metal layers for forming the contact islands leads to the opportunity to deposit these layers by means of technologies like screen printing, sputtering or evaporation without plating. Thus, the manufacturing costs can be reduced thanks to the material consumption saving.

Fourth, there is a lower stress on the solar cell when exposed to high temperature. The bulk material of the solar cell and the metal layer used for forming the contact islands present different thermal expansion coefficients resulting typically in the state of the art in cell bowing. Since thin metallization layers can be used in the present invention to form the contact islands, this bow can be reduced and the solar cell manipulation will be easier.

Fifth, since the connector lines used in the present invention are so small in width that these lines do not overlap the contact islands in the direction transverse to the longitudinal direction of the base and emitter connector lines, an undesired short circuit between the different types of contacts can be prevented in an uncomplicated way.

According to a preferred embodiment of the photovoltaic cell of the present invention, there is no electrical insulator layer between the base connector lines and the corresponding base contact islands and between the emitter connector lines and the corresponding emitter contact islands. That means, in the vertical direction of the photovoltaic cell it is not necessary to separate the base connector lines from the emitter connector lines by an insulator. This is possible because, in according with the present invention, the connector lines do not overlap the contact islands in the direction transverse to the longitudinal direction of the base and emitter connector lines. Thus, there is enough space between the different contacts and the corresponding connector lines to prevent short circuits without the necessity of an additional insulator layer. That facilitates the manufacturing of the photovoltaic cell of the present invention considerably, e.g. in comparison with the technology described in the document US 2011/0041908 A1. Nevertheless, since the connector lines are over their full width in contact with the contact islands in the cross regions, a good current collection is ensured by the connector lines used in the photovoltaic cell of the present invention.

In a further variant of the present invention, an electrical insulator is provided in the vertical direction between regions of the contact islands and the base and the emitter regions. Additionally or alternatively, insulating areas covering edge regions of adjacent emitter contact islands and being formed under and along base connector lines extending between said adjacent emitter contact islands and insulating areas covering edge regions of adjacent base contact islands and being formed under and along emitter connector lines extending between said adjacent base contact islands can be provided. The electrical insulator between the different contact islands helps to avoid a contact between the respective connector line (wire) and the inter-contact area. The insulating areas provided in the regions along the base and emitter connector lines, respectively, serve to avoid any short circuit between the contact islands of different polarity, e. g. due to a misalignment of the connector lines during contacting.

In the present invention, the connector lines can be formed from an electrical conducting material being able to be soldered, glued, taped or pressed on the photovoltaic cell.

According to a suitable variant of the present invention, the base connector lines and the emitter connector lines are ribbons extending perpendicular to the length-extension of the contact islands. These ribbons are electrically connected to contact islands of one polarity, respectively. The ribbons can be placed on the solar cell during the cells interconnection. Ribbons are available with a small width so that these ribbons are very well suited to fulfill the requirement to the connector lines of the present invention, namely to have a width being as small that overlapping of the emitter contact islands in the direction transverse to the longitudinal direction of the base and emitter connector lines can be excluded.

Preferably, the base connector lines and the emitter connector lines have width being in the region between 10 µm und 1 mm, favorably between 10 µm and 500 µm. More preferably, the width of the base connector lines and the emitter connector lines is between 50 µm and 300 µm. Exemplarily, the width of the base connector lines and the emitter connector lines is between 100 µm and 250 µm.

In a favorite example of the present invention, the base contact islands and the emitter contact islands are arranged separate from each other, wherein groups of base contact islands are connected by the crossing base connector lines, respectively, and groups of emitter contact islands are connected by the crossing emitter connector lines, respectively.

It is furthermore beneficial if groups of base contact islands and groups of emitter contact islands are connected electrically in the level of the contact islands by interconnections, respectively, wherein the interconnections extend in the longitudinal directions of the base connector lines and the emitter connector lines, respectively. Preferably, the interconnections are formed by the same material with the same doping as the material and the doping of the contact islands to be connected with the interconnection.

Favorably, the interconnections are part of the active regions of the photovoltaic cell.

It has been shown to be especially advantageous in an embodiment of the invention if the contact islands and the corresponding interconnections form a pattern of joined "H"'s.

Exemplarily, the contact islands may have a thickness of between 10 nm and 10 µm. Furthermore, the contact islands may have a width in their extension parallel to the longitudinal direction of the connector lines of between 1 µm and 5 mm. The base contact structure elements and the emitter contact structure elements may have a distance from each other of between 1 µm and 5 mm. Moreover, the distance of contact islands of same polarity in a direction transverse to the longitudinal direction of the connector lines can be between 10 µm and 5 mm.

Favorably, the base contact structure elements and the emitter contact structure elements consist of at least one material of the group of materials comprising silver, aluminum, copper, nickel, and vanadium.

It is furthermore advantageous if the base connector lines and the emitter connector lines are formed on or in or are covered by a film reflecting light into the photovoltaic cell.

In accordance with another aspect of the present invention, there is provided a photovoltaic cell module comprising at least two photovoltaic cells being formed in accordance with the present invention and being electrically connected with each other, wherein a bus bar is provided between two adjacent photovoltaic cells and interconnects the connector lines, such as ribbons, of the adjacent photovoltaic cells in such a way that connector lines connecting substrate regions of different polarities are connected.

In accordance with yet another aspect of the present invention, there is provided a photovoltaic cell module comprising at least two photovoltaic cells being formed in accordance with the present invention and being electrically connected with each other, wherein adjacent photovoltaic cells have comparable island patterns, but inversed island polarity, and wherein the adjacent photovoltaic cells are connected in such a way that a base connector line of one photovoltaic cell is continued over an adjacent photovoltaic cell to form there an emitter connector line of said adjacent photovoltaic cell. In this case, connector lines, such as ribbons, connecting one polarity of contact islands of a first solar cell are directly connected to opposite polarity of a following solar cell.

Favorable embodiments of the present invention, their structure, function and advantages are explained in the following with reference to the accompanying drawings in which
- Fig. 1: schematically shows an embodiment of a solar cell of the present invention with base and emitter contact islands distributed in a staggered way on a back side of the solar cell;
- Fig. 2: schematically shows a further embodiment of a solar cell of the present invention wherein base and emitter contact islands are distributed in a staggered way on a back side of the solar cell and wherein groups of base contact islands and groups of emitter contact islands are interconnected in the same level as the contact islands forming an "H" pattern;
- Fig. 3: schematically shows the "H" pattern of Fig. 2 in a larger scale with exemplary dimensions;
- Fig. 4: schematically shows the solar cell of Fig. 1 with base and emitter connector lines connecting groups of base and emitter contact islands, respectively;
- Fig. 5: schematically shows the solar cell of Fig. 2 with base and emitter connector lines connecting "H" patterned groups of base and emitter contact islands, respectively;
- Fig. 6: schematically shows an embodiment of a solar cell module in accordance with the present invention wherein bus bars are provided between the connected solar cells;
- Fig. 7: schematically shows another embodiment of a solar cell module in accordance with the present invention wherein solar cells with same or similar pattern but different distribution of polarities of the junction forming regions in the solar cell are placed adjacently and connected with each other by connector lines without intermediate bus bars;
- Fig. 8: schematically shows a view of a back side of a solar cell of the present invention, wherein an electrical insulator is provided between the contact islands and the emitter and base regions of the solar cell;
- Fig. 9: schematically shows a side view of the solar cell of Fig. 8 taken along the direction A - A;
- Fig. 10: schematically shows a view of the back side of a further variant of the solar cell of the present invention, wherein additional insulating areas are provided along the base and emitter connector lines; and
- Fig. 11: schematically shows a side view of the solar cell of Fig. 10 taken along the direction B - B.

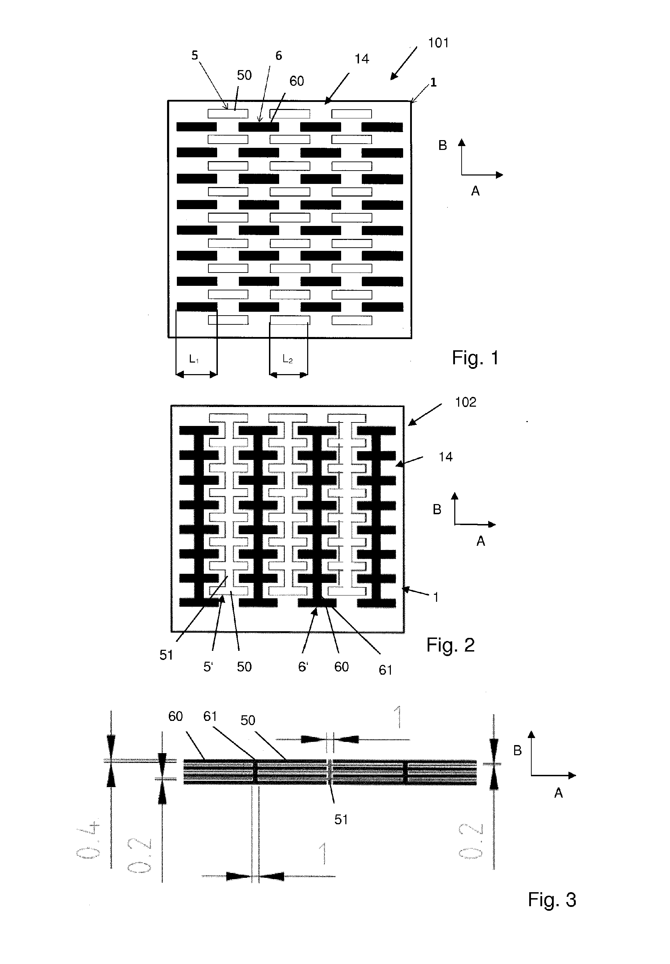

Fig. 1 schematically shows a back side of a photovoltaic cell or solar cell 101 of the present invention. The solar cell 101 is in the embodiment shown formed from a crystalline silicon substrate 1 with a back side contact structure. In other non-shown embodiment of the present invention, the solar cell 101 can also be formed of another semiconductor material. The invention can be applied on all solar cell fabrication technologies using semiconductor with different doping type. Exemplarily but not necessarily, the solar cell 101 can be a hetero junction solar cell.

The back side contact structure of the solar cell 101 comprises interdigitated base contact structure elements 5 and emitter contact structure elements 6 being formed to connect underlying differently doped regions of the solar cell 101 forming the base and the emitter of that solar cell 101. The base contact structure elements 5 comprise base contact islands 50 and the emitter contact structure elements 6 comprise emitter contact islands 60 distributed in a staggered manner on the back side 14 of the solar cell 101.

Adjacent contact islands 50, 50 or 60, 60 of same polarity as well as the contact islands 50, 60 of different polarity are spaced apart from each other. None of the contact islands 50, 60 overlap. The base contact islands 50 and the emitter contact islands 60 are arranged in rows and columns. The base contact islands 50 form a grid of base contact islands and the emitter contact islands 60 form a grid of emitter contact islands wherein the grids are staggered to each other.

The base contact islands 50 and the emitter contact islands 60 have an elongated structure. The contact islands 50, 60 have a relatively high length to width ratio and a high length to thickness (height) ration. The lengths L₁, L₂ of the base and the emitter contact islands 50, 60 are chosen in such a way that the base contact islands 50 and the emitter contact islands 60 interfinger. Preferably but not necessarily, both the base contact islands 50 and the emitter contact islands 60 of adjacent rows as well as the base contact islands 50 and the emitter contact islands 60 of adjacent columns interfinger. That means, although the contact islands 50, 60 do not overlap and are not in touch with each other, they are arranged in an interlocked, space serving manner. Thus, the contact islands 50, 60 can contact large areas of the doped regions of the solar cell 101 despite of a decreased place requirement of the respective contact islands 50, 60.

Fig. 2 schematically shows a further embodiment of a solar cell 102 of the present invention with a view on the back side 14 of the solar cell 102. The solar cell 102 comprises interdigitated base contact structure elements 5' and emitter contact structure elements 6' contacting corresponding base and emitter regions formed in the solar cell 102 with different doping. The base contact structure elements 5' comprise base contact islands 50 being similar to the base contact islands 50 of the solar cell 101 of Fig. 1. Therefore reference is made here to the above description of these base contact islands 50. In contrast to the embodiment of Fig. 1, the base contact islands of the embodiment of Fig. 2 are interconnected in the same level as the base contact islands 50 via interconnections 51. Similarly, the emitter contact structure elements 6' comprise emitter contact islands 60 being similar to the emitter contact islands 60 of the solar cell 101 of Fig. 1. Therefore reference is made here to the above description of these emitter contact islands 60. In contrast to the embodiment of Fig. 1, the emitter contact islands of the embodiment of Fig. 2 are interconnected in the same level as the emitter contact islands 60 via interconnections 61.

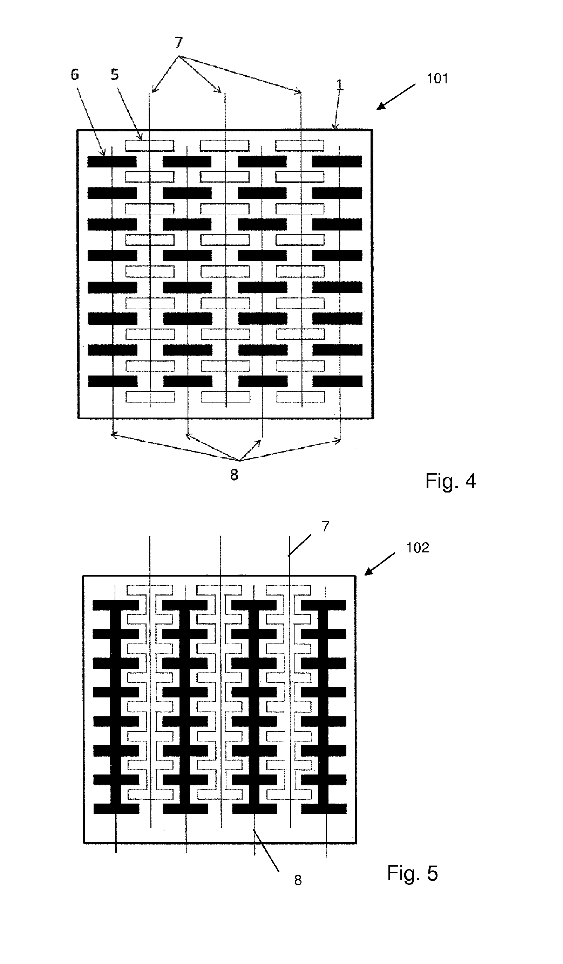

Thus, the interconnected base and emitter contact islands 50, 60 form groups of base contact islands and groups of emitter contact islands wherein each group forms a pattern of several interconnected "H"'s. The "H" pattern ensures a better islands interconnection and a larger electrical connection between the contact islands 50, 60 and the corresponding connector lines 7, 8, as shown in Figs. 4 and 5.

Exemplarily, the contact islands 50, 60 have a thickness (height) of between 10 nm and 10 µm. Furthermore, the contact islands 50, 60 have in the shown example a width in their extension in the direction B of between 1 µm and 5 mm. Typical amounts for this width are between 100 µm and 500 µm. The lengths L₁, L₂ of the contact islands 50, 60 can be in a mm to cm range. A typical value for these lengths is about 2 cm.

The base contact structure elements 5, 5' and the emitter contact structure elements 6, 6' have exemplarily a distance from each other of between 1 µm and 5 mm, preferably in the µm range, typically of about 100 µm. Moreover, the distance between contact islands 50, 60 of same polarity in the direction A parallel to the lengths L₁, L₂ of the contact islands 50, 60 is between about 10 µm and about 5 mm, typically about 1 mm.

Fig. 3 shows more specifically but only exemplarily possible dimensions by means of a detail of the solar cell 102 of Fig. 2. In the example of Fig. 3, the width of the interconnections 51, 61 is about 1 mm, the width of the contact islands 50, 60 is about 0.4 mm and the distance of the contact islands 50, 60 in the direction B transverse to the direction A of the lengths of the contact islands 50, 60 is about 0.2 mm.

Fig. 4 schematically shows the solar cell 101 of Fig. 1 with base connector lines 7 and emitter connector lines 8 connecting groups of base contact islands 50 and groups of emitter contact islands 60, respectively, in the vertical direction B of the shown solar cell 101. In each of the groups, the respective connector lines 7, 8 connect only contact islands of one polarity. That means, the connector lines 7, 8 are provided in such a way that the base connector lines 7 do not cross the emitter contact islands 60 and that the emitter connector lines 8 do not cross the base contact islands 50. The base connector lines 7 and the emitter connector lines 8 are arranged in parallel and in an alternate manner so that columns of connected base contact islands 50 alternate with columns of connected emitter contact islands 60. Each of the base and emitter connector lines 7, 8 has two distal ends wherein one distal end ends on the substrate 1 and the other distal end protrudes from a side of the substrate 1, wherein the protruding ends of the base connector lines 7 protrude from one side of the substrate 1 and the protruding ends of the emitter connector lines 8 protrude from the opposite side of the substrate 1.

As base and emitter connector lines 7, 8, preferably ribbons are used. The expression ribbon corresponds to any electrical material of any shape, such as rectangular or round, that can be soldered, glued, taped or just pressed on the solar cell.

Fig. 5 schematically shows the solar cell 102 of Fig. 2 with base connector lines 7 and emitter connector lines 8 connecting the "H" patterned groups of base and emitter contact islands 50, 60, respectively. The base connector lines 7 extend on the interconnections 51 and the emitter connector lines 8 extend on the interconnections 61 so that the "H" patterned groups of base and emitter contact islands 50, 60 can be connected to corresponding groups of an adjacent solar cell (not shown). As mentioned with reference to Fig. 4, the base and emitter connector lines 7, 8 protrude for this from opposite sides of the substrate 1.

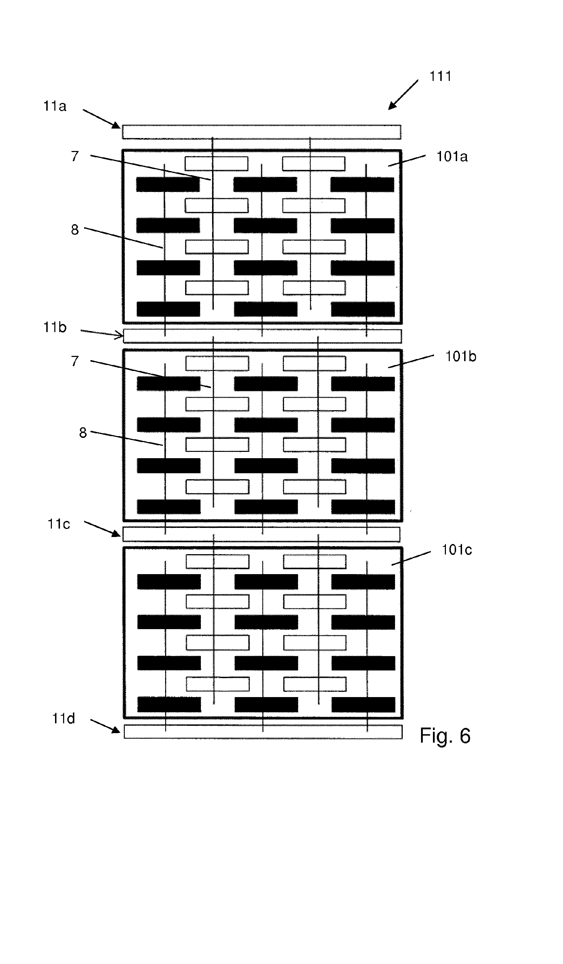

Fig. 6 schematically shows an embodiment of a solar cell module 111 in accordance with the present invention. The solar cell module 111 consists of a plurality of adjacent solar cells 101 a, 101b, 101c being similar to the solar cell 101 of Fig. 1. In another embodiment, solar cells being similar to the solar cell 102 of Fig. 2 can also be used. The solar cells 101 a, 101 b, 101 c are placed side by side wherein bus bars 11a, 11b, 11c, 11d are provided at the margins and between adjacent solar cells 101, 101. The base connector lines 7 which connect the base contact islands 50 of one solar cell 101 b end with their protruding distal ends on the bus bar 11 b wherein the emitter connector lines 8 which connect the emitter contact islands 60 end with their protruding distal ends on the opposite bus bar 11c. Furthermore, on the bus bar 11 b end the protruding distal ends of the emitter connector lines 8 connecting the emitter contact islands 60 of the solar cell 101 a, and on the bus bar 11c end the protruding distal ends of the base connector lines 7 connecting the base contact islands 50 of the solar cell 101 c. This way, regions of different polarity of the adjacent solar cells 101 a, 101 b, 101 c can be connected with each other.

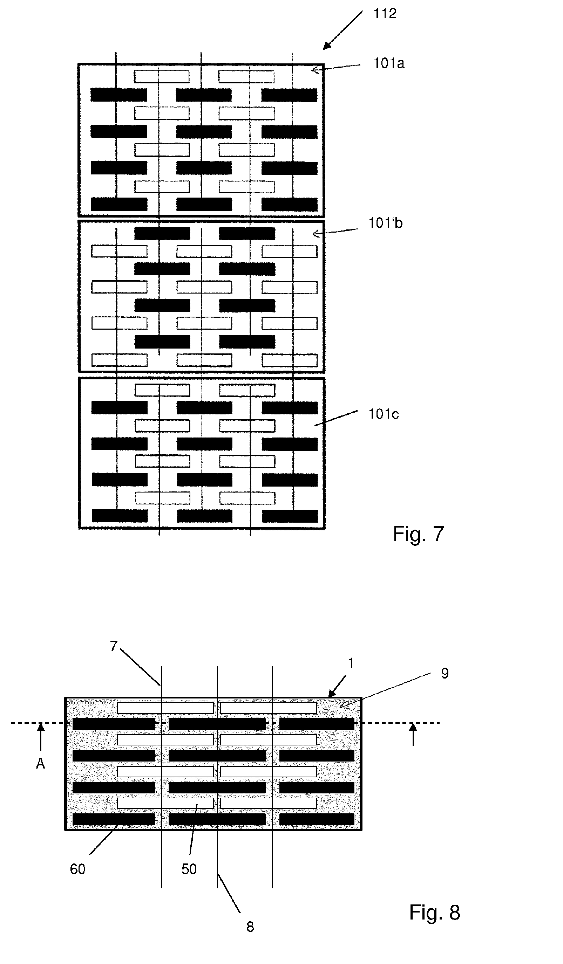

Fig. 7 schematically shows another embodiment of a solar cell module 112 in accordance with the present invention wherein solar cells 101 a, 101'b with same or similar pattern but different distribution of polarities of the junction forming regions in the solar cells 101 a, 101'b are placed directly side by side and connected with each other by connector lines 7, 8. In this embodiment, the connector lines 7, 8 form on one solar cell 101a base connector lines and form on the adjacent solar cell 101'b emitter connector lines and vice versa, since the connector lines 7, 8 extend on both adjacent solar cells 101a, 101'b, respectively. Thus, along one column, the solar cell module 112 is composed by alternating solar cells 101 a, 101'b, and only vertical connector lines 7, 8, such as ribbons, connect the solar cells 101 a, 101'b together. External bus bars are here not necessary. Moreover, this technique of interconnection allows using a smaller space between the solar cells 101a, 101'b, improving the final power density of the solar cell module 112.

Moreover, it is especially advantageous, if the base connector lines 7 and the emitter connector lines 8 are formed on or in or are covered by a film reflecting light into the solar cell 101, 102. The film reflecting light is a so-called "white film". That film can already receive the ribbons used as connector lines and then provided on the solar cell 101, 102 for concurrent interconnection and encapsulation.

Fig. 8 schematically shows a view of a back side of a solar cell of the present invention. As explained with reference to the previous figures, the solar cell of Fig. 8 comprises emitter contact islands 60 being electrically connected with emitter regions formed in the substrate of the solar cell and base contact islands 50 being electrically connected with base regions being also formed in the substrate of the solar cell. Groups of emitter contact islands 60 and groups of base contact islands 50 are connected, respectively, by emitter connector lines 8 and base connector lines 7 leading as straight wires over the emitter contact islands 60 and the base contact islands 50 of the respective group of contact islands 50, 60.

The electrical connection between the contact islands 50, 60 and the corresponding base and emitter regions in the substrate of the solar cell is not provided over the whole lengths of the contact islands 50, 60. Vertically as well as horizontally between the contact islands 50, 60, an electrical insulator 9 is provided. The electrical insulator 9 helps to avoid shunting due to a contact of the connector lines 7, 8 and the inter-contact area, that means between the wire(s) connecting the contact islands 50, 60 and amorphous or microcrystalline semiconductor areas of the solar cell, such as an intrinsic amorphous Si:H-layer formed in the substrate of the solar cell.

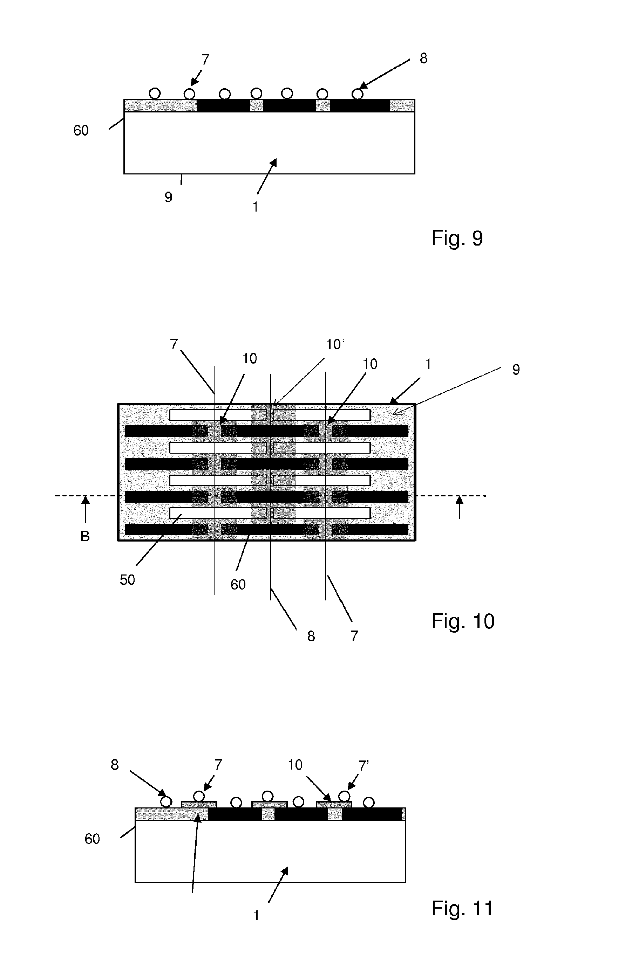

Fig. 9 schematically shows a non-true-to-scale sectional side view of the solar cell of Fig. 8 taken along the direction A - A. The section shown goes through the length direction of the emitter contact islands 60. In that section, the emitter connector lines 8 lie directly on the emitter contact islands 60. The base connector lines 7 lie on the electrical insulator 9 formed between the emitter contact islands 60. Vice-versa, in a parallel non-shown section through the solar cell going through the lengths of the base contact islands 50, it would be apparent that the base connector lines 7 lie on the base contact islands 50, wherein the emitter connector lines 8 lie on the electrical insulator 9 formed between the base contact islands 50.

The electrical insulator 9 does not only separate the contact islands 50, 50 and 60, 60 of one type and the contact islands different types 50, 60 from each other. The electrical insulator 9 further holds the base connector lines 7 and the emitter connector lines 8 on top of the electrical insulator 9. Since the electrical insulator 9 fills the gap between the contact islands 50, 50; 60, 60 and 50, 60, the base connector lines 7 and the emitter connector lines 8 do not lie in such a gap. Thus, a shunt contact between the emitter connector lines 8 and the base contact islands 50 as well as between the base connector lines 7 and the emitter contact islands 60 can be extensively prevented.

Fig. 10 schematically shows a view on the back side of a further variant of the solar cell of the present invention. In addition to the embodiment of Figs. 8 and 9, the solar cell of Fig. 10 comprises stripes of additional insulator areas 10, 10' being formed along the base and emitter connector lines 7, 8, respectively. The insulating areas 10 cover edge regions of adjacent emitter contact islands 60 of groups of emitter contact islands 60 lying vis-á-vis, respectively. Moreover, the additional insulating areas 10 are formed under and along base connector lines 7 extending between said adjacent emitter contact islands 60. The insulating areas 10' cover edge regions of adjacent base contact islands 50 and are formed under and along emitter connector lines 8 extending between said adjacent base contact islands 50. Thus, the additional insulating areas 10, 10' which cover at least partially the contact islands 50, 60 of opposite polarity help to avoid a shunt between the base contact islands 50 and the emitter contact islands 60 due to an eventual misalignment of the connector lines 7, 8 during contacting.

Fig. 11 schematically shows a non-true-to-scale sectional side view of the solar cell of Fig. 10 taken along the direction B - B. The section shown goes through the length direction of the emitter contact islands 60. Because of the additional insulating areas 10, 10' provided on top of the electrical insulator 9 and parts of the contact islands 50, 60, the base connector lines 7, 7' lie - in comparison to the embodiment shown in Fig. 9 - now on top of the insulating areas 10. Therefore, there is an additional vertical distance between the base connector lines 7 and the emitter contact islands 60 and, accordingly, between the base connector lines 7 and the emitter connector lines 8. Vice versa, in a parallel non-shown section going through the lengths of the base contact islands 50, the emitter connector lines 8 lie on top of the additional insulating areas 10' and the base connector lines 7 rest on the base contact islands 50. In this section exists also a larger vertical distance between the higher positioned emitter connector lines 8 and the lower positioned base contact islands 50 and base connector lines 7. That larger distance helps in particular in the case of a misalignment of connector lines such as the base connector line 7' in Fig. 11. The base connector line 7' is not aligned in the middle of the horizontal distance between adjacent emitter contact islands 60. Nevertheless, there is an electrical separation between the base connector line 7' and emitter contact island 60 lying thereunder by the insulating area 10, because that insulating area 10 covers not only the electrical insulator 9 but also overlaps side parts of the adjacent emitter contact islands 60.

## Claims

1. Photovoltaic cell (101, 101', 102) with at least one base of a first polarity and at least one emitter of a second polarity and having a front side for receiving light and a back side (14) opposite said front side, wherein base contact structure elements (5, 5') contacting the at least one base and emitter contact structure elements (6, 6') contacting the at least one emitter are formed on said back side separately from each other; wherein
the base contact structure elements (5, 5') are connected electrically by base connector lines (7) provided on the base contact structure elements (5, 5') and the emitter contact structure elements (6, 6') are connected electrically by emitter connector lines (8) provided on the emitter contact structure elements (6, 6'), wherein the base connector lines (7) and the emitter connector lines (8) extend longitudinally side by side, distanced from each other and alternately over the back side of the photovoltaic cell (101, 101', 102), respectively;
the base contact structure elements (5, 5') and the emitter contact structure elements (6, 6') comprise base contact islands (50) and emitter contact islands (60) being spaced apart from each other;
the base contact islands (50) and the emitter contact islands (60) have lengths (L₁, L₂) extending longitudinally in a direction (A) transverse to a longitudinal direction (B) of the base connector lines (7) and the emitter connector lines (8), respectively, and have such a length (L₁, L₂) that the base contact islands (50) and the emitter contact islands (60) interfinger; and wherein
each of the base connector lines (7) connects a group of base contact islands (50) by crossing the base contact islands (50) in the longitudinal direction (B) and each of the emitter connector lines (8) connects a group of emitter contact islands (60) by crossing the emitter contact islands (60) in the longitudinal direction (B), **characterized in that**
the base connector lines (7) and the emitter connector lines (8) have such a width in the direction (A) that there is a direct contact between each of the connector lines (7, 8) and the corresponding base contact islands (50) and emitter contact islands (60) over the full width of the connector lines (7, 8) in the regions where the base connector lines (7) cross the base contact islands (50) and in the regions where the emitter connector lines (8) cross the base connector islands (60), respectively, wherein the base connector lines (7) do not overlap the emitter contact islands (60) in the direction (A) and the emitter connector lines (8) do not overlap the base contact islands (50) in the direction (A).

2. Photovoltaic cell of claim 1, **characterized in that** there is no electrical insulator layer between the base connector lines (7) and the corresponding base contact islands (50) and between the emitter connector lines (8) and the corresponding emitter contact islands (60).

3. Photovoltaic cell of claim 1, **characterized in that** an electrical insulator (9) is provided between regions of the contact islands (50, 60) and the base and the emitter regions and/or insulating areas (10) covering edge regions of adjacent emitter contact islands (60) and being formed under and along base connector lines (7) extending between said adjacent emitter contact islands (60) and insulating areas (10') covering edge regions of adjacent base contact islands (50) and being formed under and along emitter connector lines (8) extending between said adjacent base contact islands (50) are provided.

4. Photovoltaic cell of one of the preceding claims, **characterized in that** the connector lines (7, 8) are formed from an electrical conducting material being able to be soldered, glued, taped or pressed on the photovoltaic cell (101, 101', 102).

5. Photovoltaic cell of claim 3, **characterized in that** the base connector lines (7) and the emitter connector lines (8) are ribbons.

6. Photovoltaic cell of one of the preceding claims, **characterized in that** the width of the base connector lines (7) and the emitter connector lines (8) is between 10 µm and 1 mm.

7. Photovoltaic cell of one of the preceding claims, **characterized in that** each of the base connector lines (7) crosses all base contact islands (50) formed along one line in the longitudinal direction (B) of the photovoltaic cell (1) and each of the emitter connector lines (8) crosses all emitter contact islands (60) formed along one line in the longitudinal direction (B) of the photovoltaic cell (1).

8. Photovoltaic cell of one of the preceding claims, **characterized in that** the base contact islands (50) and the emitter contact islands (60) are arranged separate from each other.

9. Photovoltaic cell of one of the claims 1 to 6, **characterized in that** the groups of base contact islands (50) and the groups of emitter contact islands (60) are connected electrically in the level of the contact islands (50, 60) by interconnections (51, 61), respectively, wherein the interconnections (51, 61) extend in the longitudinal direction (B) of the base connector lines (7) and the emitter connector lines (8), respectively, so that the contact islands (50, 60) and the corresponding interconnections (51, 61) form a pattern of joined "H"'s, and wherein the interconnections (51, 61) are part of the active regions of the photovoltaic cell (102).

10. Photovoltaic cell of one of the preceding claims, **characterized in that** the contact islands (50, 60) have a thickness of between 10 nm and 10 µm.

11. Photovoltaic cell of one of the preceding claims, **characterized in that** the contact islands (50, 60) have a width in their extension parallel to the longitudinal direction (B) of the connector lines (7, 8) of between 1 µm and 5 mm.

12. Photovoltaic cell of one of the preceding claims, **characterized in that** the base contact structure elements (5, 5') and the emitter contact structure elements (6, 6') have a distance from each other of between 1 µm and 5 mm.

13. Photovoltaic cell of one of the preceding claims, **characterized in that** the distance of contact islands (50, 60) of same polarity in the direction (A) transverse to the longitudinal direction (B) of the connector lines (7, 8) is between 10 µm and 5 mm.

14. Photovoltaic cell of one of the preceding claims, **characterized in that** the base contact structure elements (5, 5') and the emitter contact structure elements (6, 6') consist of at least one material of the group of materials comprising silver, aluminum, copper, nickel, and vanadium.

15. Photovoltaic cell of one of the preceding claims, **characterized in that** the base connector lines (7) and the emitter connector lines (8) are formed on or in or are covered by a film reflecting light into the photovoltaic cell (101, 101', 102).

16. Photovoltaic cell module (111) comprising at least two photovoltaic cells (101, 101) of one of the preceding claims being electrically connected with each other, **characterized in that** a bus bar (11) is provided between two adjacent photovoltaic cells (101, 101) and interconnects the connector lines (7, 8) of the adjacent photovoltaic cells (101, 101) in such a way that connector lines (7, 8) connecting substrate regions of different polarities are connected.

17. Photovoltaic cell module (112) comprising at least two photovoltaic cells (101, 101') of one of the claims 1 to 15 being electrically connected with each other, **characterized in that** adjacent photovoltaic cells (101, 101') have comparable island patterns, but inversed island polarity, and wherein the adjacent photovoltaic cells (101, 101') are connected in such a way that a base connector line (7) of one photovoltaic cell (101) is continued over an adjacent photovoltaic cell (101') to form there an emitter connector line (8) of said adjacent photovoltaic cell (101').
